# EUROPÄISCHE PATENTSCHRIFT

(11) **EP 0 442 064 B1**
(45) Veröffentlichungstag und Bekanntmachung des Hinweises auf die Patenterteilung: **27.03.1996**
(21) Anmeldenummer: 90123222.3
(22) Anmeldetag: 04.12.1990
(51) Int. Cl.: H01L 27/02

(54) **Eingangsschutzstruktur für integrierte Schaltungen**
Input protection structure for integrated circuits
Structure de protection d'entrée pour circuits intégrés

(30) Priorität: 15.02.1990 DE 4004752
(43) Veröffentlichungstag der Anmeldung: 21.08.1991
(73) Patentinhaber: SIEMENS AKTIENGESELLSCHAFT, D-80333 München (DE)
(72) Erfinder: Becker, Burkhard, Dr., W-8000 München 80 (DE)

(56) Entgegenhaltungen:
- FR-A- 2 335 055
- GB-A- 2 176 053
- US-A- 4 017 882
- US-A- 4 291 319
- PATENT ABSTRACTS OF JAPAN vol. 7, no. 174 (E-190)(1319), 2 August 1983, & JP-A-58 79 744
- PATENT ABSTRACTS OF JAPAN vol. 10, no. 91 (E-394)(2148), 9 April 1986, & JP-A-60 235 452
- IBM TECHNICAL DISCLOSURE BULLETIN. vol. 27, no. 3, August 1984, NEW YORK US, Seiten 1570-1571 ; J. R. CAVALIERE et al.: "ELECTROSTATIC DISCHARGE PROTECTION DEVICE IN DEEP TRENCH ISOLATION STRUCTURE"

## Beschreibung

Die vorliegende Erfindung betrifft eine Eingangsschutzstruktur für integrierte Schaltungen, die in einem Halbleitersubstrat angeordnet ist und mindestens einen Transistor und eine integrierte Diode enthält.

Integrierte Schaltungen benötigen einen sicheren Schutz gegen elektrostatische Entladungen. Zu diesem Zweck werden sie mit Eingangschutzstrukturen versehen, einige dem Stand der Technik entsprechende Strukturen sind in der DE-OS 36 16 394 erläutert.

Auch die US-A 4,017,882 zeigt einen Transistor mit integriertem Schutzelement.

Die Schrift "Patent Abstracts of Japan", vol. 7. no. 174 (E-190) [1319], 2. August 1983 & JP-A-58 079744, zeigt die Parallelschaltung eines Transistors mit unbeschalteter Basis und einer Diode.

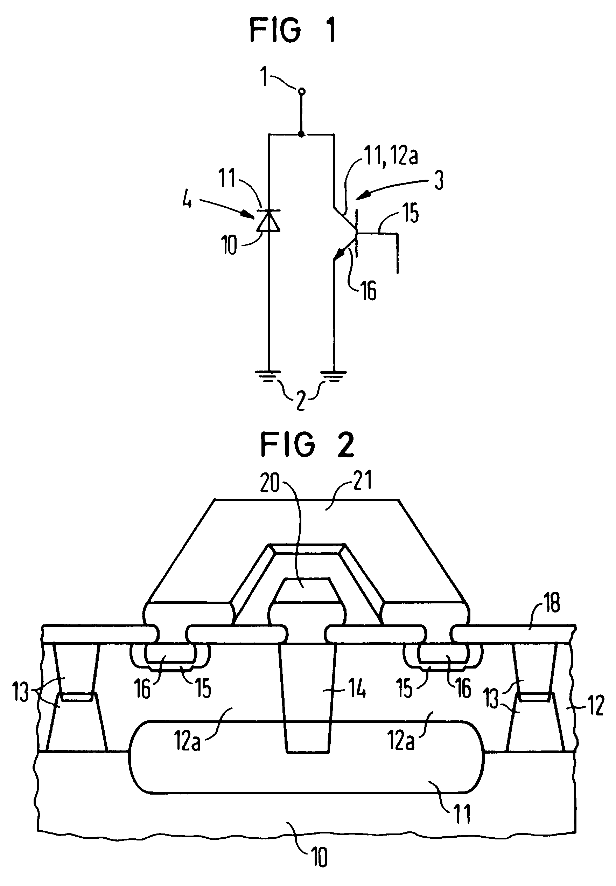

Die Schrift "Patent Abstracts of Japan", vol. 10, no. 91 (E-394) [2148], 9. April 1986 & JP-A-60 235452, zeigt dieselbe Schaltung. Deren technologische Realisierung zeigt insbesondere die dortige Figur 2. Dort sind der Transistor und die Diode getrennt voneinander integriert. Der Kollektor des Transistors ist durch eine vergrabene Zone und eine epitaktische Schicht gebildet, die Diode ist jedoch neben dem Transistor durch eine Isolationszone isoliert von diesem realisiert. Es handelt sich um eine Oberflächendiode.

Die Schrift "IBM Technical Disclosure Bulletin", vol. 27, no. 3, August 1984, Seiten 1570-1571, offenbart, daß eine integrierte Diode durch eine vergrabene Zone und das Halbleitersubstrat realisiert werden kann. Diese Diode ist dort aber neben weiteren Dioden und isoliert von diesen realisiert.

Der vorliegenden Erfindung liegt die Aufgabe zugrunde, eine Eingangsschutzstruktur für integrierte Schaltungen anzugeben, die einen schnellen und zuverlässigen Schutz gegen elektrostatische Entladungen beider Polaritäten ermöglicht.

Diese Aufgabe wird bei einer Eingangsschutzstruktur der in Rede stehenden Art erfindungsgemäß durch die Merkmale des Patentanspruchs 1 gelöst. Weiterbildungen der Erfindung sind Gegenstand von Unteransprüchen.

Die Erfindung wird im folgenden anhand von Ausführungsbeispielen gemäß den Figuren 1 bis 4 der Zeichnung näher erläutert. Es zeigt:
- Figur 1: ein Ersatzschaltbild einer Eingangsschutzstruktur mit mindestens einem Transistor und einer integrierten Diode, und
- Figuren 2 bis 4: drei Ausführungsformen der erfindungsgemäßen Realisierung einer Eingangsschutzstruktur nach Figur 1 in einem Halbleitersystem in schematischer Darstellung.

Gemäß Figur 1 liegt zwischen einem Eingangsanschluß 1 einer integrierten Schaltung, insbesondere einer bipolaren integrierten Schaltung, und einem Anschluß für ein Referenzpotential 2, insbesondere einem Masseanschluß, eine Schutzstruktur, die durch einen Transistor 3 und eine zur Kollektor-Emitter-Strecke des Transistors parallel geschaltete Diode 4 gebildet wird. Der Kollektor 11, 12a des Transistors 3 und ein Pol 11 der Diode 4 sind mit dem Eingang 1 verbunden, der Emitter 16 des Transistors 3 sowie der andere Pol 10 der Diode 4 sind an das Referenzpotential 2 anschließbar. Die Basis 15 des Transistors 3 besitzt keinen externen Anschluß (floatende Basis), sie hat nur zum Kollektor 11, 12a und zum Emitter 16 Kontakt.

In den FIG 2 bis 4 sind drei Ausführungsbeispiele der Realisierung der erfindungsgemäßen Schutzstruktur nach FIG 1 in einem Halbleitersystem dargestellt; dabei wird ein Schnittbild mit zusätzlicher Schrägaufsicht nach hinten verwendet. Die Bezugszeichen sind in Übereinstimmung mit FIG 1 gewählt. Bei allen drei Ausführungsformen wird als Grundlage ein Halbleitersubstrat 10 eines ersten Leitungstyps, vorzugsweise des p-Leitungstyps und bestehend aus Silizium, verwendet, auf welches im Laufe des Herstellverfahrens der Schutzstruktur eine epitaktische Schicht 12 des entgegengesetzten zweiten Leitungstyps, vorzugsweise also des n-Leitungstyps, mit bekannten Methoden aufgebracht wird. Ferner ist allen Ausführungsbeispielen eine vergrabene Zone 11 des zweiten Leitungstyps gemeinsam, die ebenso wie die übrigen, noch zu erläuternden dotierten Zonen mittels konventioneller Verfahren, beispielsweise Implantation mit anschließendem Temperaturschritt, erzeugt werden kann.

In dem ersten Ausführungsbeispiel gemäß FIG 2 dient ein Isolationsrahmen 13, bestehend aus dotierten Zonen des ersten Leitungstyps, zur Isolation der gesamten Schutzstruktur gegenüber benachbarten Bauelementen (pn-Isolation). Dieser geschlossene Isolationsrahmen 13 trennt einen in seinem Inneren liegenden Teilbereich 12a der epitaktischen Schicht 12 von der übrigen, außen liegenden epitaktischen Schicht 12. Der Teilbereich 12a bildet gemeinsam mit der vergrabenen Zone 11 den Kollektor des Transistors 3 und wird durch eine insbesondere hochdotierte Zone 14 desselben Leitungstyps, die vorzugsweise, aber nicht notwendigerweise, bis in die vergrabene Zone 11 hineinreicht, angeschlossen. Innerhalb des Teilbereichs 12a liegt eine dotierte Zone 15 des ersten Leitungstyps, welche die Basis des Transistors 3 darstellt, und innerhalb dieser wiederum eine dotierte Zone 16 des zweiten Leitungstyps als Emitter des Transistors 3. In vorteilhafter Weise sind die bisher erläuterten dotierten Zonen im wesentlichen zentralsymmetrisch angeordnet, d.h. die hochdotierte Zone 14 befindet sich in etwa in der Mitte des Teilbereichs 12a, die Zonen 15 und 16 führen ineinanderliegend rahmenförmig um die hochdotierte Zone 14 herum. Die vergrabene Zone 11 wird vorzugsweise so dimensioniert, daß sie unterhalb des Basis-Emitter-Ringes 15, 16 das von diesem eingeschlossene Gebiet vollständig überdeckt. Um diese gesamte Schutzstruktur herum ist der Isolationsrahmen 13 angeordnet. Die Oberfläche des Halbleitersystems ist mit einer isolierenden Schicht 18 bedeckt, die entweder bei den vorausgegangenen Temperaturschritten entstanden oder getrennt aufgebracht worden ist und vorzugsweise aus Siliziumoxid besteht. Sie ist so strukturiert, daß die hochdotierte Zone 14 mit einer Leitbahn 20 anschließbar ist, ebenso existiert in ihr eine vorzugsweise ringförmige Öffnung oberhalb der ebenfalls ringförmigen, als Emitter dienenden Zone 16. Durch sie kann der Emitter 16 über eine Leitbahn 21 an das Referenzpotential 2 angeschlossen werden. Die die Basis bildende Zone 15 ist an der Oberfläche von der isolierenden Schicht 18 vollständig überdeckt. Das Halbleitersubstrat 10 besitzt einen außerhalb der Schutzstruktur liegenden Masseanschluß, so daß die integrierte Diode 4 durch die vergrabene Zone 11 und das Halbleitersubstrat 10 gebildet ist.

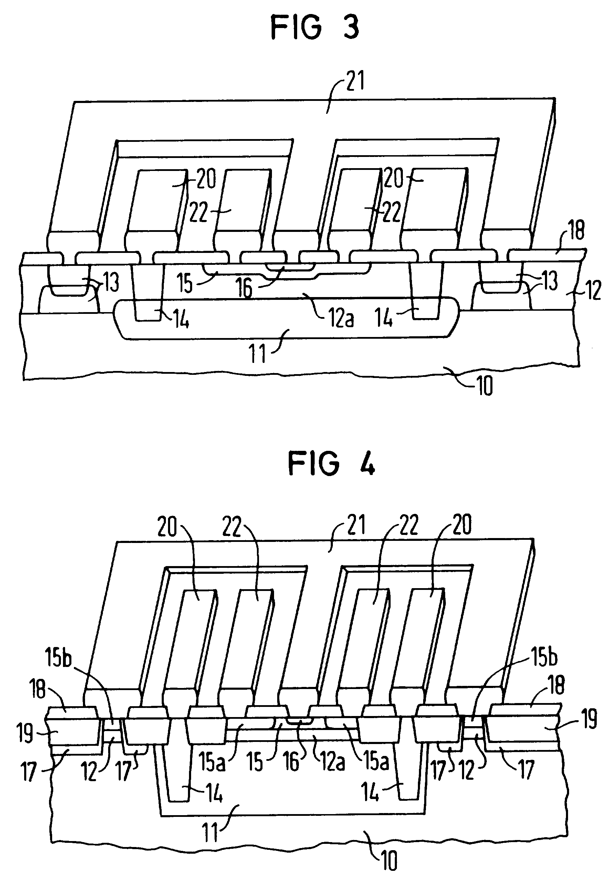

Die zweite Ausführungsform gemäß FIG 3 ist ebenfalls bei pn-Isolation benachbarter Bauelemente einsetzbar (Isolationsrahmen 13) und entspricht im wesentlichen dem ersten Ausführungsbeispiel. Jedoch wird für den Transistor 3 ein npn-Standardbauelement eingesetzt, daher ergibt sich ein mehr streifenförmiger Aufbau. Der Emitter 16 ist in der Mitte angeordnet, die ihn kontaktierende Leitbahn 21 dient gleichzeitig zum Anschluß des Halbleitersubstrats 10 über den Isolationsrahmen 13 an das Referenzpotential 2. Die Basis 15 des Transistors 3 ist im wesentlichen symmetrisch zum Emitter 16 angeordnet und kann wie in FIG 3 durch zwei entsprechend symmetrisch angeordnete Öffnungen in der isolierenden Schicht 18 mit Leitbahnen 22 verbunden sein. Diese beiden Leitbahnen 22 sind jedoch nach außen nicht weiter angeschlossen, werden jedoch vorteilhafterweise miteinander verbunden; sie sorgen für eine homogene Potentialverteilung im Basis-Gebiet, sind aber nicht unbedingt erforderlich. Der aus vergrabener Zone 11 und Teilbereich 12a der epitaktischen Schicht 12 gebildete Kollektor besitzt zwei, zum Emitter 16 im wesentlichen symmetrisch angeordnete Anschlüsse bestehend aus den hochdotierten Zonen 14, die nicht notwendigerweise bis in die vergrabene Zone 11 hineinreichen. Über die Leitbahnen 20 wird er an den Eingang 1 angeschlossen. Die integrierte Diode 4 wird durch die vergrabene Zone 11 und das Halbleitersubstrat 10 gebildet, welches über den Isolationsrahmen 13 und die Leitbahn 21 gemeinsam mit dem Emitter 16 an das Referenzpotential 2 angeschlossen wird.

In FIG 4 ist eine Ausführungsform der Erfindung bei Oxidisolation benachbarter Bauelemente unter Verwendung eines Standard-npn-Transistors dargestellt. Der Transistor 3 ist dabei im wesentlichen wie im zweiten Ausführungsbeispiel ausgebildet, die Basis 15 weist zwei zusätzliche hochdotierte Basis-Kontaktzonen 15a zum Anschluß an die Leitbahnen 22 auf. Isolierende Gebiete 19, die mindestens bis in die Tiefe der Unterkante der epitaktischen Schicht 12 reichen, dienen zur Isolation einzelner dotierter Zonen untereinander sowie der gesamten Schutzstruktur gegenüber anderen Bauelementen. Vorzugsweise handelt es sich um Feldoxid-Gebiete 19. Außerhalb der Eingangsschutzstruktur sind sie von hochdotierten Zonen 17 des ersten Leitungstyps umgeben, die als sogenannte Channel-Stopper bekannt sind. Diese Channel-Stopper-Bereiche 17 dienen hier gleichzeitig dem Anschluß des Halbleitersubstrats 10 an die Oberfläche des Halbleitersystems, wo sie einen Kontakt mit der Leitbahn 21 und einer hochdotierten Zone 15b, die gleichzeitig mit der Basis-Kontaktzone 15a erzeugt wurde und daher ebenfalls den ersten Leitungstyp aufweist, besitzen. Auf diese Weise kann das Halbleitersubstrat 10 gemeinsam mit dem Emitter 16 an das Referenzpotential 2 angeschlossen werden. Die integrierte Diode 4 wird wie in den vorhergehenden Ausführungsbeispielen durch die vergrabene Zone 11 und das Halbleitersubstrat 10 gebildet, mittels der Leitbahnen 20 und 21 wird sie zwischen Eingang und Referenzpotential geschaltet.

Die Arbeitsweise der erfindungsgemäßen Eingangsschutzstruktur ist unabhängig von der speziellen Ausführungsform:

Negative Spannungen am Eingang 1 werden über die in die Schutzstruktur integrierte Diode 4 zum Referenzpotential 2 abgeleitet. Der empfindliche Basis-Emitter-Übergang ist hier in Sperichtung gepolt, wobei der zentralsymmetrische Aufbau der FIG 2 von großem Vorteil ist. Aufgrund der ringförmigen, ausgedehnten Sperrschicht wird die Belastung auf eine größere Fläche des Emitter-Basis-Übergangs verteilt, womit der Nachteil des alleinigen Ableitpfades über die Diodenstrecke kompensiert wird. Der zentralsymmetrische Aufbau der FIG 2 gewährleistet aus diesem Grund eine für beide Spannungs-Polaritäten gleich hohe Belastbarkeit bzw. Schutzwirkung in der Größenordnung von vielen tausend Volt, obwohl die Ableitung von positiven Impulsen (siehe unten) aufgrund der in diesem Fall vorherrschenden Transistorarbeitsweise von Natur aus begünstigt ist.

Bei positiven Impulsen am Eingang 1 befindet sich der Transistor 3 im normalen Arbeitsbereich, womit der empfindliche Emitter-Basis-Übergang nur wenig belastet ist. Da die Basis 15 nicht angeschlossen ist, wird der Impuls über einen U_{CEO}-Durchbruch abgeleitet. Der Emitter-Kollektor-Reststrom I_{CEO} ist gegenüber einem Kollektor-Basis-Reststrom I_{CBO} um den Faktor B + 1 erhöht (B = Stromverstärkung). Dadurch ist ein frühzeitiger Durchbruch gewährleistet, bevor die Spannung am Eingang so stark angestiegen ist, daß eine Zerstörung die Folge wäre. Der frühzeitige Lawinendurchbruch begünstigt die zerstörungsfreie Ableitung des Impulses.

Auch hier macht sich der zentralsymmetrische Aufbau der FIG 2 positiv bemerkbar, wobei die große Emitter-Fläche 16 eine Erhöhung der Emitter-Effektivität bewirkt und damit die Ableitung des Impulses begünstigt. Andererseits entsteht durch die große Emitter-Fläche hinsichtlich einer Erhöhung der zusätzlichen Kapazität kein Nachteil, da für positive Signalspannungen nur die Übergänge zwischen epitaktischer Schicht und Basis-Gebiet sowie vergrabener Zone 11 und Substrat 10, d.h. zwischen Gebieten mit relativ schwachen Dotierungen, ausschlaggebend sind.

Für integrierte Schaltungen mit pn-Isolation bietet sich aufgrund der oben ausgeführten Überlegungen die Verwendung der Struktur der FIG 2 an, welche neben den Vorteilen eines geringen Flächenbedarfs, einer kleinen zusätzlichen Kapazität sowie einer für beide Spannungs-Polaritäten gleichermaßen hervorragenden Schutzwirkung nur den Nachteil eines aufgrund des nicht angeschlossenen Basis-Gebietes erhöhten Sperrstroms besitzt.

Bei Verwendung eines Standard-npn-Transistors gemäß der FIG 3 vermindert die aufgrund der die Basis 15 kontaktierenden Leitbahnen 22 erzeugte homogenere Potentialverteilung innerhalb des Basis-Gebietes das Auftreten von lokalen Sperrschicht-Durchbrüchen, welche aufgrund der räumlich begrenzten Leistung zur Zerstörung führen können.

Bei integrierten Schaltungen mit Oxid-Isolation ist die Verwendung einer symmetrischen Struktur gemäß der FIG 4 sinnvoll, wobei man hier im allgemeinen nicht mit dem Nachteil erhöhter Sperrströme rechnen muß. Vorteilhafterweise werden bei dieser Struktur zwei hochdotierte, symmetrisch zum Emitter angeordnete Basis-Kontakt-Zonen 15a verwendet, welche mitsamt ihrer Leitbahnen 22 (nicht angeschlossen) zur Homogenisierung der Potentialverteilung in der Basis-Zone 15 (im allgemeinen schwach dotiert) beitragen.

Darüberhinaus vermindern die Basis-Kontakt-Zonen 15a die Ausdehnung der Sperrschicht zwischen epitaktischer Schicht und Basis-Gebiet (beide Gebiete sind im allgemeinen schwach dotiert) bei positiven Impulsen, wodurch ein Lawindendurchbruch erst bei hohen anliegenden Spannungen zur Zerstörung führt.

## Patentansprüche

1. Eingangsschutzstruktur für integrierte Schaltungen, welche
- zwischen einen Eingang (1) einer integrierten Schaltung und einen Anschluß für ein Referenzpotential (2) geschaltet ist,
- einem Halbleitersubstrat (10) eines ersten Leitungstyps und einer auf dem Halbleitersubstrat (10) aufgebrachten epitaktischen Schicht (12) eines zweiten Leitungstyps angeordnet ist, und
- mindestens einen Transistor (3) und eine integrierte Diode [4] enthält, wobei
-- der Kollektor des Transistors durch eine vergrabene Zone (11) des zweiten Leitungstyps und den darüberliegenden Teilbereich (12a) der epitaktischen Schicht (12) gebildet ist und an den Eingang (1) der integrierten Schaltung mittels eines Kollektoranschlusses angeschlossen ist, welcher von einer auf dem genannten Teilbereich (12a) der epitaktischen Schicht (12) angeordneten ersten Leitbahn (20) und einer hochdotierten Zone (14) des zweiten Leitungstyps gebildet ist, die unterhalb dieser Leitbahn (20) in dem genannten Teilbereich (12a) der epitaktischen Schicht (12) angeordnet ist,
-- mindestens eine als Basis (15) des Transistors wirkende dotierte Zone des ersten Leitungstyps in dem genannten Teilbereich (12a) der epitaktischen Schicht (12) so angeordnet ist, daß sie abgesehen vom elektrischen Kontakt zum Emitter (16) und zum Kollektor des Transistors isoliert ist,
-- mindestens eine als Emitter (16) des Transistors wirkende dotierte Zone des zweiten Leitungstyps in der Basiszone (15) gebildet und mittels einer zweiten Leitbahn(21) an das Referenzpotential (2) angeschlossen ist,
-- die integrierte Diode (4) parallel zur Kollektor-Emitter-Strecke des Transistors (3) geschaltet und durch die vergrabene Zone (11) sowie das mit dem Referenzpotential verbundene Halbleitersubstrat (10) gebildet ist, und
-- die vergrabene Zone (11) innerhalb eines Isolationsrahmens (13) oder isolierender Gebiete (19) angeordnet ist, der oder die sich durch die epitaktische Schicht (12) erstrecken und den genannten Teilbereich (12a) elektrisch von der übrigen epitaktischen Schicht (12) trennen.

2. Eingangsschutzstruktur nach Anspruch 1, bei der die hochdotierte Zone (14) bis in die vergrabene Zone (11) reicht.

3. Eingangsschutzstruktur nach Anspruch 1 oder 2, mit einer zentralsymmetrischen Anordnung des Emitter-Basis-Gebiets um den Kollektoranschluß.

4. Eingangsschutzstruktur nach Anspruch 1 oder 2, bei der mehrere Kollektoranschlüsse vorgesehen und mit dem Kollektor symmetrisch zum Emitter-Basis-Bereich des Transistors angeordnet sind.

5. Eingangsschutzstruktur nach Anspruch 4, bei der die als Basis (15) wirkende dotierte Zone einen elektrischen Kontakt zu dritten Leitbahnen (22) aufweist, welche von allen übrigen Strukturen der Schutzstruktur isoliert sind und zur Homogenisierung des Potentialverlaufs innerhalb der Basis (15) dienen.

6. Verwendung der Eingangsschutzstruktur nach einem der vorherigen Ansprüche bei bipolar integrierten Schaltungen mit einer pn-Isolation oder Oxid-Isolation benachbarter Bauelemente.

## Claims

1. Input protection structure for integrated circuits, which
- is connected between an input (1) of an integrated circuit and a connection for a reference potential (2),
- is arranged in a semiconductor substrate (10) of a first conductance type and in an epitaxial layer (12), which is applied on the semiconductor substrate (10), of a second conductance type, and
- contains at least one transistor (3) and one integrated diode (4),
-- the collector of the transistor being formed by a buried zone (11) of the second conductance type and that partial region (12a) of the epitaxial layer (12) which is located above it, and being connected to the input (1) of the integrated circuit by means of a collector connection, which is formed by a first conductive track (20), which is arranged on the said partial region (12a) of the epitaxial layer (12), and a highly doped zone (14) of the second conductance type, which zone (14) is arranged underneath this conductive track (20) in the said partial region (12a) of the epitaxial layer (12),
-- at least one doped zone, which acts as the base (15) of the transistor, of the first conductance type being arranged in the said partial region (12a) of the epitaxial layer (12) such that it is insulated apart from the electrical contact to the emitter (16) and to the collector of the transistor,
-- at least one doped zone, which acts as the emitter (16) of the transistor, of the second conductance type being formed in the base zone (15) and being connected to the reference potential (2) by means of a second conductive track (21),
-- the integrated diode (4) being connected in parallel with the collector-emitter path of the transistor (3) and being formed by the buried zone (11) and the semiconductor substrate (10) which is connected to the reference potential, and
-- the buried zone (11) being arranged within an insulation frame (13) or insulating regions (19) which extends or extend through the epitaxial layer (12) and isolates or isolate the said partial region (12a) electrically from the rest of the epitaxial layer (12).

2. Input protection structure according to Claim 1, in which the highly doped zone (14) extends into the buried zone (11).

3. Input protection structure according to Claim 1 or 2, having a centrally symmetrical arrangement of the emitter-base region around the collector connection.

4. Input protection structure according to Claim 1 or 2, in the case of which a plurality of collector connections are provided and are arranged, with the collector, symmetrically with respect to the emitter-base region of the transistor.

5. Input protection structure according to Claim 4, in the case of which the doped zone, which acts as the base (15), has an electrical contact to third conductive tracks (22) which are insulated from all the other structures of the protection structure and are used to homogenize the potential profile within the base (15).

6. Use of the input protection structure according to one of the preceding claims in the case of bipolar integrated circuits having pn-insulation or oxide insulation of adjacent components.

## Revendications

1. Structure de protection d'entrée pour circuits intégrés, qui
- est branchée entre une entrée (1) d'un circuit intégré et une borne pour un potentiel (2) de référence,
- est disposée dans un substrat (10) semi-conducteur d'un premier type de conduction et dans une couche (12) épitaxiale d'un second type de conduction se trouvant sur le substrat (10) semi-conducteur, et
- comprend au moins un transistor (3) et une diode intégrée (4),
-- le collecteur du transistor étant formé d'une zone (11) enterrée du second type de conduction et du domaine partiel (12a) de la couche (12) épitaxiale, qui se trouve au-dessus et le collecteur du transistor étant connecté à l'entrée (1) du circuit intégré au moyen d'une borne de collecteur, qui est formée d'une première piste (20) conductrice disposée sur ledit domaine partiel (12a) de la couche épitaxiale (12) et d'une zone (14) du second type de conduction et à grand dopage, qui est disposée sous cette piste (20) conductrice dans ledit domaine (12a) partiel de la couche épitaxiale (12),
-- au moins une zone dopée du premier type de conduction et agissant comme base (15) du transistor est disposée dans ledit domaine partiel (12a) de la couche épitaxiale (12) de sorte à être isolée abstraction faite du contact électrique avec l'émetteur (16) et avec le collecteur du transistor,
-- au moins une zone dopée du second type de conduction et agissant comme émetteur (16) du transistor est formée dans la zone (15) de base et est connectée au potentiel (2) de référence au moyen d'une seconde piste (21) conductrice,
-- la diode intégrée (4) étant branchée en parallèle avec la voie collecteur-émetteur du transistor (3) et étant formée de la zone enterrée (11) ainsi que du substrat semi-conducteur (10) relié au potentiel de référence, et
-- la zone (11) enterrée est disposée dans un cadre (13) d'isolation ou région (19) isolante, qui s'étend au travers de la couche épitaxiale (12) et qui isole électriquement de la couche épitaxiale restante (12) ledit domaine partiel (12a).

2. Structure de protection d'entrée suivant la revendication 1, dans laquelle la zone (14) de grand dopage pénètre jusque dans la zone enterrée (11).

3. Structure de protection d'entrée suivant la revendication 1 ou 2, ayant une disposition, symétrique par rapport à un centre, de la région émetteur-base autour de la borne de collecteur.

4. Structure de protection d'entrée suivant la revendication 1 ou 2, dans laquelle plusieurs bornes de collecteur sont prévues et ont leur collecteur disposé symétriquement par rapport au domaine émetteur-base du transistor.

5. Structure de protection d'entrée suivant la revendication 4, dans laquelle la zone dopée agissant comme base (15) comporte un contact électrique vers des troisièmes pistes (22) conductrices, qui sont isolées de toutes les autres structures de la structure de protection et qui sont destinées à l'homogénéisation de la courbe de potentiel dans la base (15).

6. Utilisation de la structure de protection d'entrée suivant l'une des revendications précédentes dans des circuits intégrés à transistors bipolaires comportant une isolation pn ou une isolation par oxyde de composants voisins.
